# EUROPEAN PATENT SPECIFICATION

(11) **EP 1 889 941 B1**
(45) Date of publication and mention of the grant of the patent: **18.06.2014**
(21) Application number: 07015895.1
(22) Date of filing: 13.08.2007
(51) Int. Cl.: C23C 14/34, C23C 14/56, F21V 7/22, G02B 5/08, C23C 14/20, C23C 28/02

(54) **Metal multi-layered film structure and method of manufacturing and use of the same**
Mehrschichtige Metallfilmstruktur und Verfahren zu deren Verwendung und Herstellung
Structure de film multicouches métallique et son procédé de fabrication et d'utilisation

(30) Priority: 14.08.2006 JP 2006221058
(43) Date of publication of application: 20.02.2008
(73) Proprietor: STANLEY ELECTRIC CORPORATION, Tokyo-to (JP)
(72) Inventor: Suzuki, Yoshio, Meguro-ku Tokyo (JP); Suzuki, Akira, Meguro-ku Tokyo (JP)
(74) Representative: Geyer, Ulrich F.

(56) References cited:
- WO-A-03/042423
- MA E ET AL: "Nucleation and growth during reactions in multilayer Al/Ni films: the early stage of Al3Ni formation" JOURNAL OF APPLIED PHYSICS USA, vol. 69, no. 4, 15 February 1991 (1991-02-15), pages 2211-2218, XP002491421 ISSN: 0021-8979
- ASHMANIS I ET AL: "High corrosion resistant reflective coatings" PROC ANNU TECH CONF SOC VAC COATERS; PROCEEDINGS, ANNUAL TECHNICAL CONFERENCE - SOCIETY OF VACUUM COATERS 1996 SOC OF VACUUM COATERS, ALBUQUERQUE, NM, USA, 1996, pages 353-356, XP008095155

## Description

### BACKGROUND OF THE INVENTION

### Field of the Invention

The present invention relates to a metal multi-layered film structure and method of forming the same, and more particularly to a metal multi-layered film structure formed on a resin substrate by sputtering and method of manufacturing the same. It also relates to an extension reflector for vehicles having the metal multi-layered film structure.

### Description of the Related Art

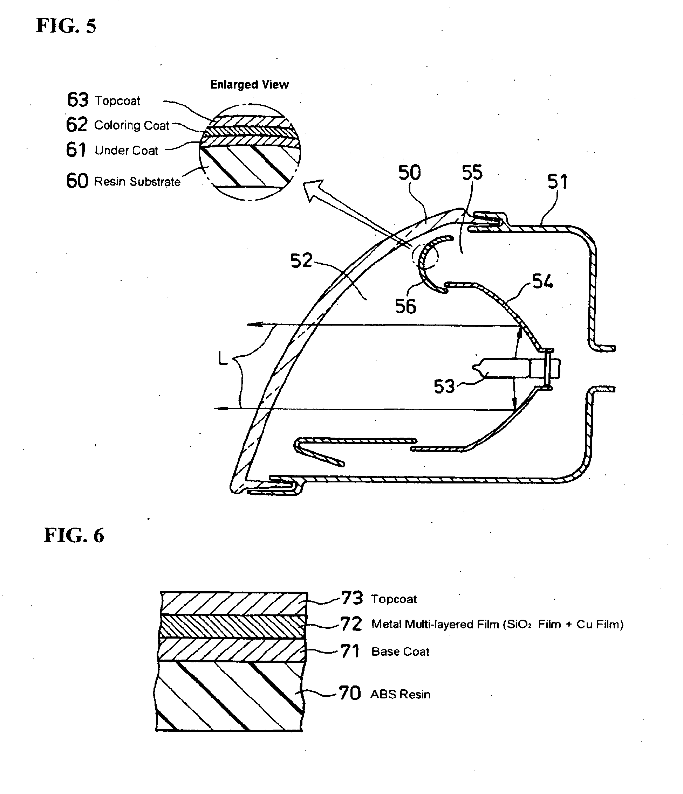

A fundamental structure of a vehicular lamp is shown in Fig. 5. A lens cover 50 and a lamp body 51 form a lamp chamber 52, which houses a light source bulb 53 and a reflector 54 located around the light source bulb 53. The light L emitted from the light source bulb 53 toward the reflector 54 is reflected from the reflector 54 and released through the lens cover 50 to the front of the lamp.

When the above-configured vehicular lamp is observed from the front while the light source is turned off in the daytime, the lamp body 51 located behind a gap 55 formed between the reflector 54 and the lamp body 51 can be seen through the lens cover 50. and through the gap. This fact extremely deteriorates the appearance as the lamp.

In particular, there is a vehicular lamp comprising a plurality of lamp bodies each including a light source bulb and a reflector in combination within a lamp chamber. In such the case, the lamp body located behind can be seen through the gap formed between the reflector and the lamp body, and additionally through the gap formed between adjacent reflectors. This fact further deteriorates the appearance.

To prevent an occurrence of such the problem, an extension reflector 56 is disposed within the lamp chamber 52 in a region relatively less related to the optical system. The extension reflector 56 covers the lamp body 51 located behind to enhance the appearance. In addition, it forces the observer to visually identify the extension reflector 56 that receives extraneous light, thereby producing a refined appearance design to be impressed.

An example of a general structure of the extension reflector 56. is shown in Fig. 5 as an enlarged view. It comprises a resin substrate 60, on which an under coat 61 composed of an acrylic-based resin or the like for smoothing the rough surface of the resin substrate is applied and dried/cured. On the under coat, a coloring coat 62 for giving the lamp an upgrade image and for refining and chromatically differentiating the appearance design of the lamp is applied and dried/cured. Further on the color coat, a topcoat 63 for protection is applied and dried/cured to complete a multi-layered film structure.

Another example of forming a multi-layered film on a resin substrate is shown in Fig. 6. The film comprises an ABS resin 70, on which a polyester urethane-based base coat 71 is applied and dried. On the base coat, a metal multi-layered film 72 is formed by forming SiO₂ (ceramic) films and Cu films alternately or simultaneously by sputtering. Further on the metal multi-layered film, an acrylic urethane-based topcoat 73 is applied and dried to complete a brilliant multi-layered film in this method (see JP-A 62-89859, for example).

The multi-layered film structure shown in the enlarged view of Fig. 5 requires at least three coating steps for the under coat, the coloring coat and the protection film coat (topcoat). In addition, it also requires time for drying/ curing after coating in each of the coating steps. Therefore, it requires time and effort until the multi-layered film is formed and causes a problem associated with poor production efficiency.

The formation of films through coating causes the multi-layered film structure to have a total film thickness of about 20 µm or more, which correspondingly increases the material expense and elevates the production cost.

The repetition of a series of coating steps including coating and drying/curing increases the degree of attachment of the dirt to the coated surface during the steps and may lower the yield possibly.

An organic solvent is used as a solvent for coating. It is though desired to hold back the use of the organic solvent not only from the viewpoint of environments but also from the viewpoint of health of workers.

On the other hand, as for the multi-layered film structure shown in Fig. 6, the base coat and the topcoat are formed by coating, ant the metal multi-layered film composed of SiO₂ films and Cu films are formed by sputtering. Therefore, it requires different types of facilities in the steps of forming the multi-layered film, such as a coating facility and a sputtering facility, which increase the amount of money invested in the production facilities. In addition, handling between the different types of facilities lowers the production efficiency and yield, becoming a factor to elevate the production cost.

The SiO₂ films and Cu films described in JP-A-62-89859 both have a single-layered film thickness of around 50 nm, which is thicker as the film thickness formed by sputtering, and extends time for film formation correspondingly. Therefore, an increase in the number of film formations results in an elongated time for film formations and increasingly lowers the production efficiency.

MA E ET AL: "Nucleation and growth during reactions in multilayer Al/Ni films: the early stage of Al3Ni formation" JOURNAL OF APPLIED PHYSICS USA, vol. 69, no. 4, 15 February 1991, pages 2211-2218, XP002491421 ISSN: 0021-8979 relates to solid state interdiffusion reactions at Al/Ni interfaces in multilayer films. Multilayer films were prepared by alternate electron-beam evaporation in high- and ultrahigh-vacuum systems, onto either glass slides coated with photoresist or oxidized silicon wafers. The multilayer films were designed to yield an overall composition ratio of three Al to one Ni. The modulation period ranged from 20 to 300 nm. The total thickness of the multilayer film divided by the number of interfaces ranged from 10 to 150 nm.

WO 03/042423 A1 discloses a vacuum sputterring apparatus capable of depositing a plurality of thin film layers on a substrate, the apparatus comprising: a vacuum chamber having gas inlet means and gas evacuation means; a substrate support table arranged to be rotatable about at least one axis perpendicular to the plane of the table; means for rotating the substrate support table about said at least one axis; a plurality of sputtering targets spaced around the walls of the chamber, each sputtering target having electrode means associated therewith; and means for altering the position of the substrate support table relative to each one of the plurality of sputtering targets such that in use a substrate placed on the substrate support table may have a film deposited thereon of atoms sputtered from at least one of the said plurality of targets and subsequently, following alteration of the position of the substrate support table, have at least one further film deposited thereon by exposure to atoms form at least one other of said plurality of targets. A method of depositing multi-layer materials on a substrate and a method of controlling stoichiometry of deposited alloys are also provided.

ASHMANIS I ET AL: "High corrosion resistant reflective coatings" PROC ANNU TECH CONF SOC VAC COATERS; PROCEEDINGS, ANNUAL TECHNICAL CONFERENCE - SOCIETY OF VACUUM COATERS 1996 SOC OF VACUUM COATERS, ALBUQUERQUE, NM, USA, 1996, pages 353-356, XP008095155 discloses a reflective coating consisting of alternated layers of titanium and aluminium, and was used as a basis for the preamble of claim 1.

### SUMMARY OF THE INTENTION

An object of the present invention is to solve the above problems to provide a metal multi-layered film structure on a resin substrate and method of manufacturing the same. Namely, it is to provide a metal multi-layered film structure excellent in durability at a lower Material expense under safe working environments in a short time with an excellent yield.

The present invention is directed to a metal multi-layered film structure, as set forth in claim 1.

The present invention is also directed to a method of manufacturing a metal multi-layered film structure, as set forth in claim 5.

The present invention is further directed to an extension reflector for vehicular lamps having the above-described metal multi-layered film structure or a metal multi-layered film structure formed through the above-described method of manufacturing.

The present invention makes it possible to form the metal multi-layered film on the resin substrate only by sputtering. As a result, the amount of money invested in production facilities can be suppressed low and the reduction in the production efficiency and yield caused on handing between different types of facilities can be avoided. Accordingly, the production cost can be reduced greatly.

The method of the present invention includes no coating step in the film forming steps and the steps are all performed in a vacuum container. Therefore, coating works and accompanying time for drying/curing are not required. Thus, it is possible to improve the production efficiency, exclude the influence from floating matters such as dust and dirt, and form a reliable multi-layered film. In addition, no use of any solvent can ensure working environments that do not impair health of workers.

The metal multi-layered film structure of the present invention has as thin a single-layered film thickness as 20 nm or less for each metal. Therefore, even an increase in the number of layers can keep the total film thickness of around 20-100 nm, which is extremely thinner than a coated film thickness. Accordingly, it is possible tq enhance the effect of reducing the material expense and the effect of shortening the film forming time.

### BRIEF DESCRIPTION OF THE DRAWINGS

Fig. 1 is a schematic diagram of a film forming device used in the present invention.
Fig. 2 shows process steps of manufacturing a metal multi-layered film structure of the present invention.
Fig. 3 shows graphs illustrative of spectroreflectance in Example 1 and Comparative Examples 2, 3, 4.
Fig. 4 shows metallurgical micrographs of Example and Comparative Examples after heat resistance tests.
Fig. 5 is a cross-sectional view of a vehicular lamp of the prior art.
Fig. 6 shows a structure of a multi-layered film of the prior art.

### DETAILED DESCRIPTION OF THE EMBODIMENTS

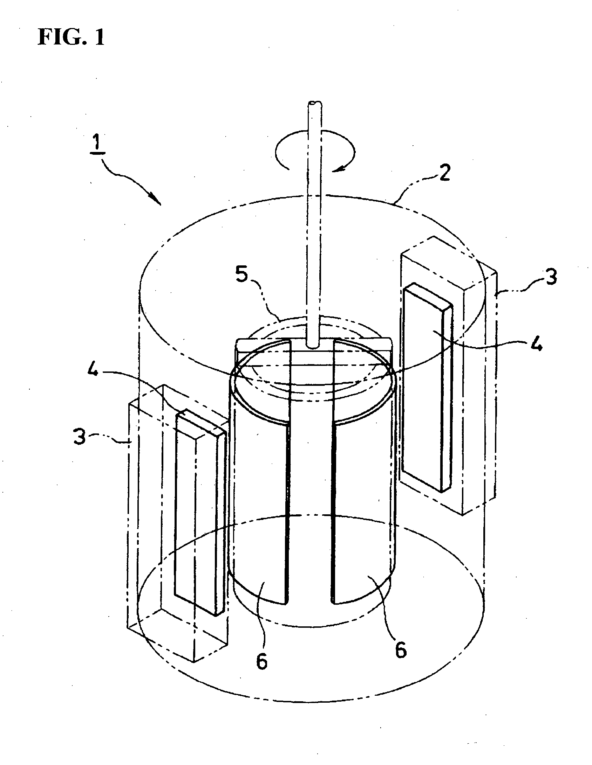

Fig. 1 is a schematic diagram of a film forming device used in a method of manufacturing a metal multi-layered film structure of the present invention. The film forming device 1 uses a batch-type DC magnetron sputtering device. The device comprises a vacuum container 2, and two cathodes 3, 3 fixedly supported thereon. Different types of metal targets 4, 4, are attached to the cathodes, respectively. A substrate holder 5 is rotatably supported as opposed to both the metal targets 4, 4. Resin substrates 6, 6 for receiving films formed thereon are attached to the substrate holder. In Fig. 1, the cathodes and metal targets are respectively provided two though they may be provided more than two, for example, four or six. In Fig. 1, the resin substrates are provided two though they may be provided one or three or more.

The air is exhausted from inside the vacuum container 2 for depressurization to a certain pressure, then an inert gas is introduced into the vacuum container to replace the inside thereof by an inert gas ambient.

Thereafter, metal atoms emitted from the metal targets 4 as spattered by ions of the inert gas are layered alternately on the resin substrates 6, 6 attached to the rotating substrate holder 5 to form a metal multi-layered film. This film is composed of two types of metal layers formed alternately on the resin substrate 6.

The first metal of the two types of metal targets is an aluminum-based material. The aluminum-based material may be high-purity aluminum or an aluminum alloy if it contains 90 % or more aluminum. The second metal is a stainless steel-based material. A typical example is SUS 304 that contains 18 % chromium and 8 % nickel in iron. In addition, SUS 304L, SUS 303, SUS 316L as well as SUS 300-series austenite-based material, SUS 430-containing ferrite-based material, and SUS 410-containing martensite-based material are targeted.

The aluminum-based material in the metal multi-layered film structure of the present invention has a single-layered film thickness of 0.7-20 nm, more preferably 0.7-10 nm. A film thickness thinner than 0.7 nm is not preferable because shading or cracking may occur in a heat resistance test. A film thickness thicker than 20 nm is not preferable because a dropped part may be whitened or vanished in an alkali resistance test. The layer composed of stainless steel-based materials has a single-layered film thickness of 1-20 nm, more preferably 1-10 nm. A film thickness thinner than 1 nm is not preferable because a dropped part may be whitened or vanished in an alkali resistance test. A film thickness thicker than 20 nm is not preferable because shading or cracking may occur in a heat resistance test.

The metal multi-layered film according to the present invention includes films preferably in 2-100 layers, more preferably in 6-20 layers. Films in more than 100 layers cause a stress, which may lead to a distortion-relatedproblem possibly. The metal in the surface adjacent to the resin substrate may be either the first metal or the second metal. Preferably, it is the first metal. The resin substrate may be undercoated, if required, prior to formation of the multi-layered film thereon.

Preferably, the multi-layered film has a thickness of 20-100 nm- It may partially exceed 100 nm in thickness if the film is formed on an item having a curved surface, such as an extension reflector.

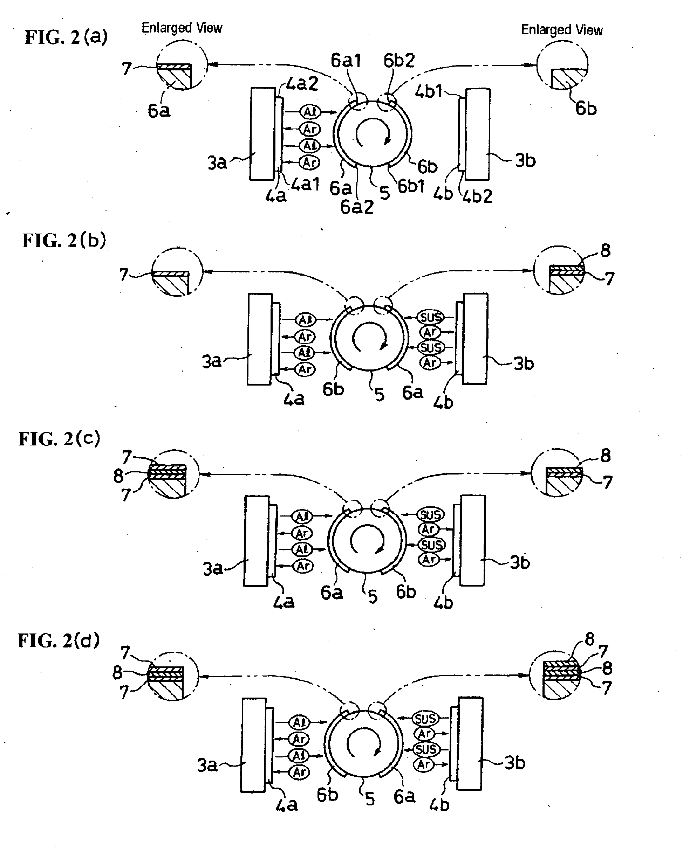

The preferred embodiments of the present invention will now be described with reference to Figs. 2-4 in detail (denoting the same parts with the same reference numerals). The below-described embodiments are preferred specific examples of the present invention and accordingly given various technically preferable limitations. The scope of the present invention is though not limited to these embodiments unless a special statement is given to limit the invention in the following description. The following Examples 1-4 show examples that use an aluminum-based material as the first metal and a stainless steel as the second metal. A nickel-based material, a cobalt-based material, a titanium-based material or a chromium-based material may be used as the second metal instead of the stainless steel. It is easily understood in such the case that the film can be formed in a similar manner as in Examples 1-4.

### EXAMPLE 1

Figs. 2A-D show the steps of forming a metal multi-layered film structure of the present invention. The film forming steps are advanced in the order as shown in Figs. 2A, B, C, D, and repeated. A vacuum container (not shown) houses the substrate holder 5 rotatably supported about the central axis, and two stationary cathodes 3a, 3b located outward from the substrate holder. An aluminum target 4a is attached to the cathode 3a while a stainless steel (SUS 304) target 4b is attached to the cathode 3b. Two polybuthylene terephthalate (PBT) substrates 6a, 6b are attached to the rotatably supported substrate holder 5.

The vacuum container is exhausted to 4 × 10⁻³ Pa, then an argon (Ar) gas is introduce at a flow rate of 550 ccm to form an Ar ambient inside the vacuum container.

Fig. 2A shows the state of forming an Al film on the PBT substrate 6a. When one end 6al of the PBT substrate 6a reaches a position opposite to one end 4a1 of the aluminum target 4a as the substrate holder 5 with the PBT substrates 6a, 6b attached thereto rotates, electrostatic discharge from the aluminum target 4a is started. During a period after the substrate holder 5 is started to rotate at the beginning of electrostatic discharge until the other end 6a2 of the PBT substrate 6a reaches a position opposite to the other end 4a2 of the aluminum target 4a, an aluminum (Al) film 7 is formed on the PBT substrate 6a.

Fig. 2B shows the state of forming a stainless steel film on the A1 film on the PBT substrate 6a and the state of forming an Al film on the PBT substrate- 6b at the same time. When one end 6al of the PBT substrate 6a reaches a position opposite to one end 4b1 of the stainless steel target 4b as the substrate holder 5 rotates, electrostatic discharge from the stainless steel target 4b is started. During a period after the substrate holder 5 is started to rotate at the beginning of electrostatic discharge until the other end 6a2. of the PBT substrate 6a reaches a position opposite to the other end 4b2 of the stainless steel target 4b, a stainless steel (SUS) film 8 is additionally formed on the aluminum (Al) film 7 formed on the PBT substrate 6a. At the same time, an Al film 7 is formed on the PBT substrate 6b by electrostatic discharge from the aluminum target 4a.

In Fig. 2C, when the PBT substrate 6a passes the position opposite to the aluminum target 4a and the PBT substrate 6b passes the position opposite to the stainless steel target 4b as the substrate holder 5 rotates, an A1 film 7 is formed on the PBT substrate 6a and a SUS film 8 on the PBT substrate 6b.

In Fig. 2D, when the PBT substrate 6a passes the position opposite to the stainless steel target 4b and the PBT substrate 6b passes the position opposite to the aluminum target 4a as the substrate holder 5 is rotated, a SUS film 8 is formed on the PBT substrate 6a and an Al film 7 on the PBT substrate 6b.

At the time of completion of the operation in Fig. 2D, a multi-layered film of 4 layers has been formed on the PBT substrate 6a, which includes the Al film 7, the SUS film 8, the A1 film 7 and the SUS film 8 sequentially from the PBT substrate 6a . In addition, a multi-layered film of 3 layers has been formed on the PBT substrate 6b, which includes the A1 film 7, the SUS film 8 and the A1 film 7 sequentially from the PBT substrate 6b.

The above operation is repeated to form a multi-layered film of 10 layers on each of the PBT substrates 6a, 6b attached to the rotating substrate holder 5 by forming Al films and SUS films both in 5 layers alternately.

In the film forming steps, the number of revolutions of the substrate holder 5 is 30 revolutions per minute, and the time for discharge from the targets 4a, 4b is about 10 seconds. The discharge power supplied to the targets during that time is DC 20 kW.

The multi-layered films formed on the PBT substrates 6a, 6b have a single-layered film thickness of 1.4 nm for the aluminum film, and 3 .4 nm for the stainless film. The whole multi-layered film has a film thickness of 24 nm.

### EXAMPLE 2

The number of revolutions of the substrate holder 5 is set at 30 revolutions per minute, and the time for discharge from the targets 4a, 4b is set at about 20 seconds. During that time, Al films and SUS films are formed alternately each in 10 layers to form a multi-layered film of 20 layers. The discharge power supplied to the targets is set at DC 10 kW. Besides, the flow rate of the Ar gas introduced into the vacuum container and the materials of the targets are determined same as those in Example 1.

The multi-layered films formed on the PBT substrates have a single-layered film thickness of 0.7 nm for the aluminum film, and 1.7nm for the stainless film. The whole multi-layered film has a film thickness of 24 nm.

### EXAMPLE 3

The number of revolutions of the substrate holder 5 is set at 15 revolutions per minute, and the time for discharge from the targets 4a, 4b is set at about 12 seconds. During that time, Al films and SUS films are formed alternately each in 3 layers to form a multi-layered film of 6 layers. The discharge power supplied to the targets is set at DC 20 kW. Besides, the flow rate of the Ar gas introduced into the vacuum container and the materials of the targets are determined same as those in Example 1.

The multi-layered films formed on the PBT substrates have a single-layered film thickness of 2.8 nm for the aluminum film, and 6.8 nm for the stainless film. The whole multi-layered film has a film thickness of 28.8 nm.

### EXAMPLE 4

The number of revolutions of the substrate holder 5 is set at 15 revolutions per minute, and the time for discharge from the targets 4a, 4b is set at about 40 seconds. During that time, A1 films and SUS films are formed alternately each in 10 layers to form a multi-layered film of 20 layers. The discharge power supplied to the aluminum target is set at DC 20 kW and the discharge power supplied to the stainless steel target is set at DC 10 kW. Besides; the flowrate of the Ar gas introduced into the vacuum container and the materials of the targets are determined same as those in Example 1.

The multi-layered films formed on the PBT substrates have a single-layered film thickness of 2.8 nm for the aluminum film, and 3 .4 nm for the stainless film. The whole multi-layered film has a film thickness of 62 nm.

The metal multi-layered film structure of the present invention can be realized through the following methods, in addition to the batch method as in the above Examples. For example, an in-line, a turn-back, a cluster and other methods can be used if they can form films in multiple layers alternately on the resin substrate using the two types of metal targets. In the above Examples, the use of a cylindrical substrate holder is exemplified though such a system may be employed that rotates the substrate holder horizontally to achieve sputtering with the two types of metal targets fixedly installed. Alternatively, the two types of metal targets may be fixedly installed inside the vacuum container to allow the resin substrate holder to rotate around the targets.

### COMPARATIVE EXAMPLES 1-4

Sputtering is applied toproduce a single-layered aluminum film (film thickness: 50 nm) on a PBT substrate as Comparative Example 1; a single-layered stainless steel (SUS 304) film (film thickness: 50 nm) on a PBT substrate as Comparative Example 2; a single-layered chromium film (film thickness: 50 nm) on a PBT substrate as Comparative Example 3; a single-layered titanium film (film thickness: 50 nm) on a PBT substrate as Comparative Example 4.

Table 1 shows test conclusions from a heat resistance test, a moisture proof test, a thermal cycle test and an alkali resistance test on the multi-layered metal films obtained in Examples 1-4 and the single-layered metal films obtained in Comparative Examples 1-4. The test conditions and the criteria of judgement for the test conclusions are as follows.
(1) Heat Resistance Test
   Test Condition: Left in an ambient at a temperature of 160 °C for 24 hours
   Criteria of Judgement (Surface Condition):
      ⊚ mark - metallic luster; ○ mark - slightly shaded;
      Δ mark - shaded yellow; × mark - shaded/cracked
(2) Moisture Proof Test
   Test Condition: Left in an ambient at a temperature of 50 °C and humidity of 98 % for 240 hours
   Criteria of Judgement (Surface Condition):
      ⊚ mark - metallic luster; Δ mark - white spots;
      × mark - whitened whole
(3) Thermal Cycle Test
   Test Condition: Normal temperature → temperature of (-40 °C) → temperature of 80 °C and humidity of 98%, varied in a cycle over 8 hours, implemented 10 cycles over 80 hours
   Criteria of Judgement (Surface Condition):
      ⊚ mark - metallic luster; Δ mark - shaded yellow;
      × mark - cracked
(4) Alkali Resistance Test
   Test Condition: Immersed into a solution of 1% potassium hydroxide for 10 minutes, then washed with water
   Criteria of Judgement (Surface Condition):
      ⊚ mark - metallic luster; ○ mark - slightly shaded
      at dropped parts; Δ mark - whitened at dropped
      parts; × mark - whitened/vanished at dropped parts

**Table 1**

| Class. | NO. | Test Conclusions | | | |
|---|---|---|---|---|---|
| | | Heat Resistance | Moisture Proof | Thermal Cycle | Alkali Resistance |
| Examples | 1 | ⊚ | ⊚ | ⊚ | ⊚ |
| | 2 | ○ | ⊚ | ⊚ | ⊚ |
| | 3 | ⊚ | ⊚ | ⊚ | ⊚ |
| | 4 | ⊚ | ⊚ | ⊚ | ○ |
| Comparative Examples | 1 | ⊚ | × | Δ | × |
| | 2 | × | ⊚ | ⊚ | ⊚ |
| | 3 | × | ⊚ | ⊚ | ⊚ |
| | 4 | × | ⊚ | ⊚ | ⊚ |

It can be found from Table 1 that Examples 1-4 of the present invention have greatly improved performances, particularly in heat resistance, over Comparative Examples 1-4.

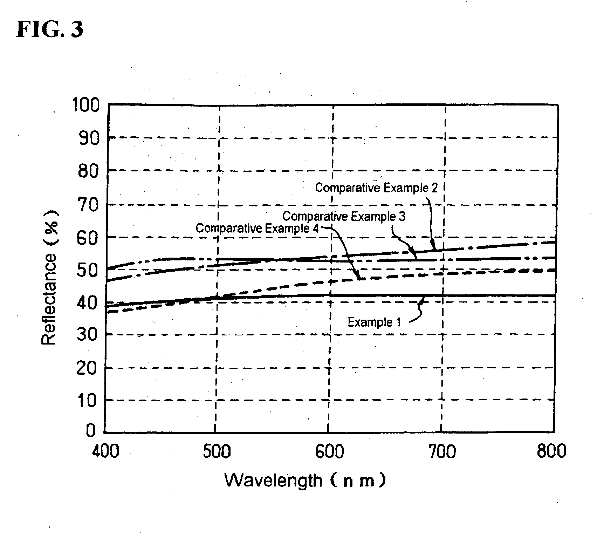

Fig. 3 shows graphs illustrative of spectroreflectance of the metal films obtained in Example 1 and Comparative Examples 2, 3 and 4. Example 1 shows reflectance unchanged over the whole visible light region. Therefore, it is possible to obtain a certain tinge with the depth of a metallic tone on observation of the metal film. In contrast, Comparative Example 2 composed of a single stainless steel film, Comparative Example 3 composed of a single chromium film, and Comparative Example 4 composed of a single titanium film have reflectance lowered in the short wave region within the visible light region. Accordingly, a yellow light having a complementary of a colored light in the short wave region is emphasized and deteriorates the design.

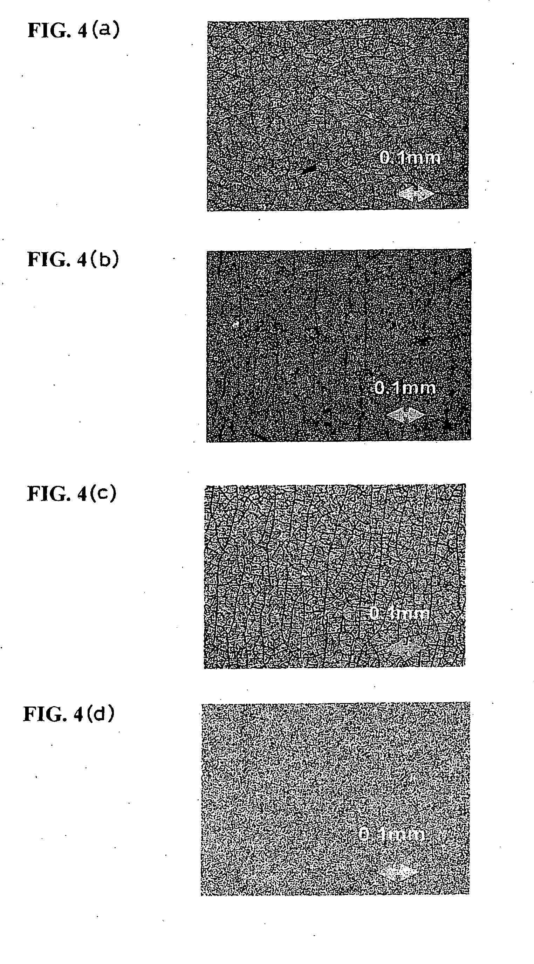

Fig. 4 shows photographs of the metal film-formed surfaces taken through a metallurgical microscope after heat resistance tests in which the metal films obtained in Example 1 and Comparative Examples 2, 3 and 4 are left in an ambient at a temperature of 160 °C for 24 hours. Fig. 4A shows a microphotograph of Comparative Example 2, Fig. 4B that of Comparative Example 3, Fig. 4C that of Comparative Example 4, and Fig. 4D that of Example 1. Cracks are found in the film-formed surfaces of Comparative Examples 2-4 each composed of a single metal film. In contrast, Cracks are hardly found in the metal multi-layered film structure of Example 1. Accordingly, it can be found that the metal multi-layered film structure makes it possible to achieve high-quality film formations.

The metal multi-layered film structure of the present invention is applicable to reflectors and extension reflectors for vehicular lamps, reflectors for general illuminators, general decorative items, the decorative uses for machine devices, the noise-cut uses and so forth.

## Claims

1. A metal multi-layered film structure, comprising two types of metal films including first metal films and second metal films alternately formed on a resin substrate,
wherein the first metal films are composed of an aluminum-based material having a film thickness ranging from 0.7 nm to 20 nm; **characterized in that** the second metal films are composed of stainless steel-based materials having a film thickness ranging from 1 nm to 20 nm.

2. The metal multi-layered film structure according to claim 1, wherein the first metal film locates proximate to the resin substrate.

3. The metal multi-layered film structure according to claim 1, wherein the second metal film locates proximate to the resin substrate.

4. The metal multi-layered film structure according to any one of claims 1-3, wherein the metal multi-layered film structure includes metal films in two layers or more but not more than 100 layers.

5. A method of manufacturing a metal multi-layered film structure, comprising the step of:
providing a sputtering device including a substrate holder rotatably supported in a container, and a plurality of cathodes fixedly arranged in the container, for attaching at least one resin substrate to the outer surface of the substrate holder;
attaching two types of metal targets to the plurality of cathodes;
providing an inert gas ambient in the container; and
rotating the resin substrate-attached substrate holder about the central axis while sputtering the two types of metal targets to form metal films over the resin substrate sequentially and alternately,
wherein the inert gas is an argon gas,
wherein one of the metal targets is composed of an aluminum-based material,
wherein the other of the metal targets is composed of stainless steel-based materials, and
wherein the method further comprises using the targets for manufacturing the metal films with a thickness being equal to or less than 20 nm.

6. An extension reflector for vehicular lamps having the metal multi-layered film structure according to any one of claims 1-4.

7. An extension reflector for vehicular lamps having the metal multi- layered film structure formed through the method according to claim 5.

## Patentansprüche

1. Mehrschichtige Metallfilmstruktur, die zwei Arten von Metallfilmen aufweist, einschließlich erster Metallfilme und zweiter Metallfilme, die abwechselnd auf einem Harzsubstrat gebildet sind,
wobei die ersten Metallfilme aus einem aluminiumbasierten Material mit einer Filmdicke, die von 0,7 nm bis 20 nm reicht, bestehen;
**dadurch gekennzeichnet, dass** die zweiten Metallfilme aus edelstahlbasierten Materialien mit einer Filmdicke, die von 1 nm bis 20nm reicht, bestehen.

2. Mehrschichtige Metallfilmstruktur gemäß Anspruch 1, wobei der erste Metallfilm nahe des Harzsubstrats gelegen ist.

3. Mehrschichtige Metallfilmstruktur gemäß Anspruch 1, wobei der zweite Metallfilm nahe des Harzsubstrats gelegen ist.

4. Mehrschichtige Metallfilmstruktur gemäß einem der Ansprüche 1-3, wobei die mehrschichtige Metallfilmstruktur Metallfilme in zwei oder mehr Schichten aber nicht mehr als 100 Schichten aufweist.

5. Verfahren zur Herstellung einer mehrschichtigen Metallfilmstruktur, das die folgenden Schritte aufweist:
Vorsehen einer Beschichtungs- bzw. Sputtervorrichtung, die eine Substrathaltevorrichtung aufweist, die in drehbarer Weise in einem Behälter gelagert ist, sowie einer Vielzahl von Kathoden, die in feststehender Weise in dem Behälter angeordnet sind, zur Anbringung von zumindest einem Harzsubstrat an der Außenoberfläche der Substrathaltevorrichtung;
Anbringen von zwei Arten von Metallzielen an der Vielzahl von Kathoden;
Vorsehen einer Inertgasumgebung in dem Behälter; und
Drehen der Substrathaltevorrichtung, an der das Harzsubstrat angebracht ist,
um die Mittelachse, während die zwei Arten von Metallzielen gesputtert werden, um Metallfilme auf dem Harzsubstrat aufeinanderfolgend und abwechselnd zu bilden,
wobei das Inertgas ein Argongas ist,
wobei eines der Metallziele aus einem aluminiumbasierten Material besteht,
wobei das andere der Metallziele aus edelstahlbasierten Materialen besteht,
und
wobei das Verfahren ferner das Nutzen der Ziele zur Herstellung der Metallfilme mit einer Dicke von 20 nm oder weniger aufweist.

6. Ausdehnungsreflektor für Fahrzeugscheinwerfer, der die mehrschichtige Metallfilmstruktur gemäß einem der Ansprüche 1-4 aufweist.

7. Ausdehnungsreflektor für Fahrzeugscheinwerfer, der die mehrschichtige Metallfilmstruktur aufweist, die durch das Verfahren gemäß Anspruch 5 gebildet wird.

## Revendications

1. Structure de films métalliques multicouches comprenant deux types de films métalliques incluant des premiers films métalliques et des seconds films métalliques formés alternativement sur un substrat de résine,
dans laquelle les premiers films métalliques sont constitués d'un matériau à base d'aluminium ayant une épaisseur de film dans une plage de 0,7 à 20 nm ;
**caractérisée en ce que** les seconds films métalliques sont constitués de matériaux à base d'acier inoxydable ayant une épaisseur de film dans une plage de 1 à 20 nm.

2. Structure de films métalliques multicouches selon la revendication 1, dans laquelle le premier film métallique est disposé à proximité du substrat de résine.

3. Structure de films métalliques multicouches selon la revendication 1, dans laquelle le second film métallique est disposé à proximité du substrat de résine.

4. Structure de films métalliques multicouches selon l'une quelconque des revendications 1 à 3, dans laquelle la structure de films métalliques multicouches inclut des films métalliques en deux couches ou plus, mais pas plus de 100 couches.

5. Procédé de fabrication d'une structure de films métalliques multicouches comprenant les étapes suivantes :
prévoir un dispositif de pulvérisation incluant un porte-substrat dans une enceinte et une pluralité de cathodes disposées de façon fixe dans l'enceinte pour maintenir au moins un substrat de résine sur la face externe du porte-substrat ;
fixer deux types de ciblesmétalliques à la pluralité de cathodes ;
prévoir une ambiance de gaz inerte dans l'enceinte ; et
faire tourner le porte-substrat sur lequel est fixé le substrat de résine autour de l'axe central tandis que l'on pulvérise les deux types de cibles métalliques pour former des films métalliques sur le substrat de résine séquentiellement et alternativement,
dans lequel le gaz inerte est de l'argon,
dans lequel l'une des cibles métalliques est constituée d'un matériau à base d'aluminium,
dans lequel l'autre des cibles métalliques est constituée de matériaux à base d'acier inoxydable, et
dans lequel le procédé comprend en outre l'utilisation des cibles pour fabriquer les films métalliques avec une épaisseur égale ou inférieure à 20 nm.

6. Réflecteur pour phares de véhicule comportant la structure de films métalliques multicouches selon l'une quelconque des revendications 1 à 4.

7. Réflecteur pour phares de véhicule comportant la structure de films métalliques multicouches formée par le procédé selon la revendication 5.
